# EUROPEAN PATENT SPECIFICATION

(11) **EP 0 633 615 B1**
(45) Date of publication and mention of the grant of the patent: **04.11.1998**
(21) Application number: 94304837.1
(22) Date of filing: 01.07.1994
(51) Int. Cl.: H01L 33/00, H01L 31/0203

(54) **Resin coating method for semiconductor laser and photodiode chips**
Harzbeschichtungsverfahren für Halbleiterlaser- und Photodioden-Chips
Méthode d'application d'une résine pour des puces laser à semi-conducteur et à photodiode

(30) Priority: 05.07.1993 JP 165519/93
(43) Date of publication of application: 11.01.1995
(73) Proprietor: SHARP KABUSHIKI KAISHA, Osaka-shi, Osaka-fu 545 (JP)
(72) Inventor: Ichikawa, Hideki, Ikoma-shi, Nara-ken (JP); Chikugawa, Hiroshi, Kashihara-shi, Nara-ken (JP)
(74) Representative: Suckling, Andrew Michael

(56) References cited:
- EP-A- 0 607 700
- PATENT ABSTRACTS OF JAPAN vol. 016, no. 408 (E-1255) 28 August 1992 & JP-A-04 137 580 (SHARP CORP) 12 May 1992
- PATENT ABSTRACTS OF JAPAN vol. 017, no. 436 (C-1096) 12 August 1993 & JP-A-05 096 229 (FUJITSU LTD) 20 April 1993
- PATENT ABSTRACTS OF JAPAN vol. 007, no. 204 (E-197) 9 September 1983 & JP-A-58 103 132 (KONISHIROKU SHASHIN KOGYO KK) 20 June 1983
- PATENT ABSTRACTS OF JAPAN vol. 005, no. 133 (E-071) 25 August 1981 & JP-A-56 070 635 (MATSUSHITA ELECTRIC IND CO LTD) 12 June 1981
- PATENT ABSTRACTS OF JAPAN vol. 006, no. 226 (E-141) 11 November 1982 & JP-A-57 130 422 (HITACHI SEISAKUSHO KK) 12 August 1982

## Description

### BACKGROUND OF THE INVENTION

### 1. Field of the Invention

The present invention relates to a resin coating method for a semiconductor laser device, and more particularly to a method for coating surfaces of a semiconductor laser chip and a photodiode chip constituting a semiconductor laser device with a resin.

### 2. Description of the Prior Art

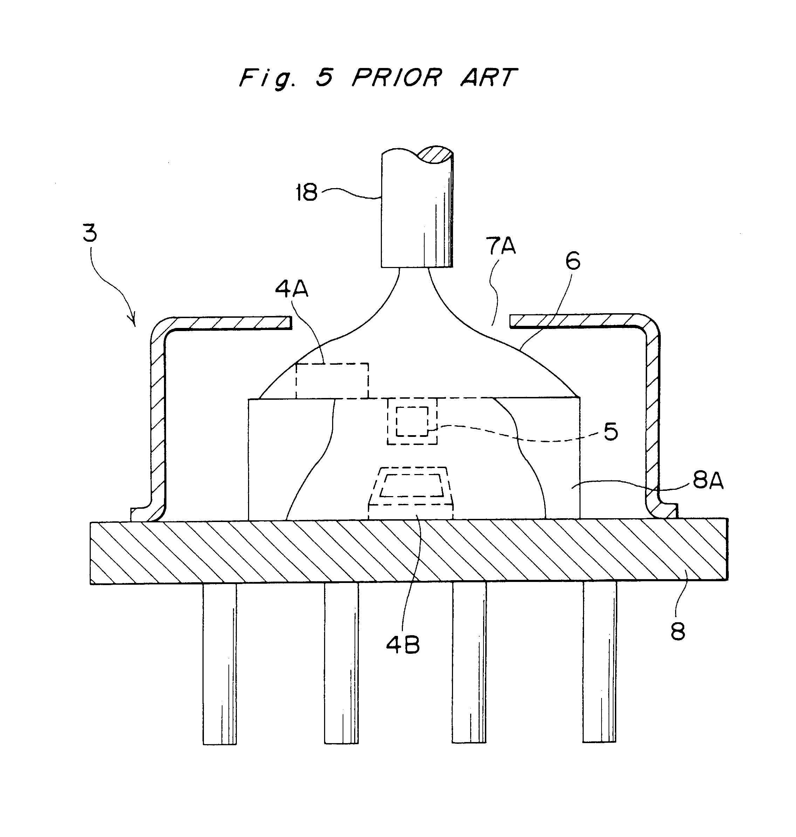

As shown in Fig. 5, there have been many methods of constructing a semiconductor laser device 3 by mounting a semiconductor laser chip 5 and photodiode chips 4A and 4B on a projecting portion 8A of a stem 8 and covering them with a cap 7 having a laser beam emission window 7A. The photodiode chip 4A serves to receive a laser beam reflected on an object (not shown), while the photodiode chip 4B serves to monitor an output of the semiconductor laser chip 5.

Conventionally, as shown in Fig. 5, the surfaces of the chips 5, 4A, and 4B have been coated with a resin 6 potted (dropped) inside the cap 7 by means of an injector 18. With the resin coating, the semiconductor laser device is allowed to have an improved reliability.

However, according to the above-mentioned conventional resin coating method, the resin 6 has been merely potted inside the cap 7. Therefore, the resin 6 has been superfluously heaped up thickly on the semiconductor laser chip 5 and the photodiode chips 4A and 4B, which has resulted in an ununiformed thickness of the resin to exert bad influence on the optical characteristics of the semiconductor laser device 3.

EP-A-0 607 700, which is prior art under Article 54(3) EPC for all states (DE, FR, NL), discloses a semiconductor laser device of the type shown in Fig. 5. The laser chip and the photodiode are covered by a resin layer which is less than 500µm thick.

JP-A-5 096 229 discloses a method of applying a resin layer to a square substrate. The resin is placed on the centre of the substrate, and the substrate is rotated so as to spread the resin over the substrate. Rotation of the substrate would tend to cause turbulence since it is square, and gas is directed towards the substrate to reduce the turbulence.

JP-A-56 070 635 discloses a method of coating a substrate with a layer of photoresist. The substrate is held over a tank of liquid photoresist and is lowered towards the liquid. The liquid is then vibrated, and the vibrations of the liquid cause the liquid to come into contact with the substrate.

The present invention provides a method of resin coating a semiconductor laser device wherein a semiconductor laser chip and a photodiode chip are mounted on a stem and the chips are covered with a cap which has a laser beam emission window at a top portion of the cap, the method comprising the step of:
dropping resin on both the chips inside the cap through the laser beam emission window;
wherein the method further comprises the steps of applying an external force on the dropped resin to remove a superfluous portion of the dropped resin from the surfaces of both the chips whereby the thickness of the resin coating on both chips is reduced to less than 500µm.

In a preferred embodiment, the method further comprises the step of fixing the stem to a turntable with the laser beam emission window opened upward; and the step of applying the external force on the dropped resin comprises spinning the turntable around a spindle which extends in a direction approximately perpendicular to the turntable to cause a superfluous portion of the dropped resin to flow towards an internal wall of the cap.

In a preferred embodiment the method further comprises the step of mounting an air blow device having a gas inlet and a gas outlet around the laser beam emission window; and
the step of applying the external force on the dropped resin comprises directing a gas from the gas inlet into the cap and discharging the gas from the gas, outlet to the outside of the cap to discharge a superfluous portion of the dropped resin to the outside of the cap with the gas.

In a preferred embodiment the method further comprises the step of fixing the stem to a specified supersonic vibrator with the laser beam emission window opened upward; and
the step of applying the external force on the dropped resin comprises vibrating the supersonic vibrator in an approximately horizontal direction to scatter a superfluous portion of the dropped resin toward an internal wall of the cap.

In a preferred embodiment the stem is affixed to the turntable at a position radially distant from the spindle.

With the above-mentioned arrangements the resin forms a thin, uniform layer on the surfaces of the semiconductor laser chip and the photodiode chip; both chips are coated thinly and uniformly with the resin.

According to a resin coating method for a semiconductor laser device of another embodiment, a gas is made to flow from a gas inlet of an air blow device into the cap, and the gas is discharged from a gas outlet of the air blow device to the outside of the cap to discharge a superfluous portion of the dropped resin to the outside of the cap together with the gas.

With the above-mentioned arrangement, the dropped resin remains thinly and uniformly on the surfaces of the semiconductor laser chip and the photodiode chip. Therefore, both the chips are coated thinly and uniformly with the resin.

According to a resin coating method for a semiconductor laser device of another embodiment, a supersonic vibrator mounted with a stem is vibrated in an approximately horizontal direction to scatter a superfluous portion of the dropped resin toward the internal wall of the cap.

With the above-mentioned arrangement, the dropped resin remains thinly and uniformly on the surfaces of the semiconductor laser chip and the photodiode chip. Therefore, both the chips are coated thinly and uniformly with the resin.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
Fig. 1 is a perspective view for explaining a resin coating method in accordance with a first embodiment of the present invention;
Fig. 2 is a longitudinal sectional view for explaining the resin coating method of the first embodiment;
Fig. 3 is a longitudinal sectional view for explaining a resin coating method in accordance with a second embodiment of the present invention;
Fig. 4 is a plan view for explaining a resin coating method in accordance with a third embodiment of the present invention;
Fig. 5 is a longitudinal partially sectional view showing a conventional process of potting a resin into a cap of a semiconductor laser device;
Fig. 6 is a front view of a part of a semiconductor laser device showing a direction in which a laser beam is emitted from a laser chip which is not coated with resin;
Fig. 7 is a side view of the semiconductor laser device shown in Fig. 6;
Fig. 8 is a graph showing a far-field pattern (FFP) of the semiconductor laser device shown in Figs. 6 and 7;
Fig. 9 is a front view of a part of a semiconductor laser device showing a direction in which a laser beam is emitted from a laser chip which is coated with resin merely by a potting method;
Fig. 10 is a side view of the semiconductor laser device shown in Fig. 9;
Fig. 11 is a partially enlarged view of Fig. 10;
Fig. 12 is a graph showing a far-field pattern (FFP) of the semiconductor laser device shown in Figs. 9 and 10;
Fig. 13 is a front view of a part of a semiconductor laser device showing a direction in which a laser beam is emitted from a laser chip which is uniformly coated with a resin by spin, air blow, or supersonic vibration;
Fig. 14 is a side view of the semiconductor laser device shown in Fig. 13;
Fig. 15 is a graph showing a far-field pattern (FFP) of the semiconductor laser device shown in Figs. 13 and 14;
Fig. 16 is a partially sectional front view showing the state of a resin coating inside a semiconductor laser device after spin coating;
Fig. 17 is a side view of the semiconductor laser device shown in Fig. 16;
Fig. 18 is a partially sectional front view showing the state of a resin coating inside a semiconductor laser device after air blow;
Fig. 19 is a side view of the semiconductor laser device shown in Fig. 18;
Fig. 20 is a partially sectional front view showing the state of a resin coating inside a semiconductor laser device after supersonic application; and
Fig. 21 is a side view of the semiconductor laser device shown in Fig. 20.

### DETAILED DESCRIPTION OF THE PREFERRED EMBODIMENTS

The following describes in detail the resin coating method for a semiconductor laser device of the present invention based on several embodiments.

It is assumed that the same semiconductor laser device 3 as shown in Fig. 5 is coated with a resin (fluorine based resin) 6. In detail, the semiconductor laser device 3 has a construction in which a semiconductor laser chip 5 and photodiode chips 4A and 4B are mounted on a projecting portion 8A of a stem 8, and the chips 5, 4A and 4B are covered with a cap 7 having a laser beam emission window 7A. The photodiode chip 4A serves to receive a laser beam reflected on an object (not shown), while the photodiode chip 4B serves to monitor an output of the semiconductor laser chip 5.

### (First Embodiment)

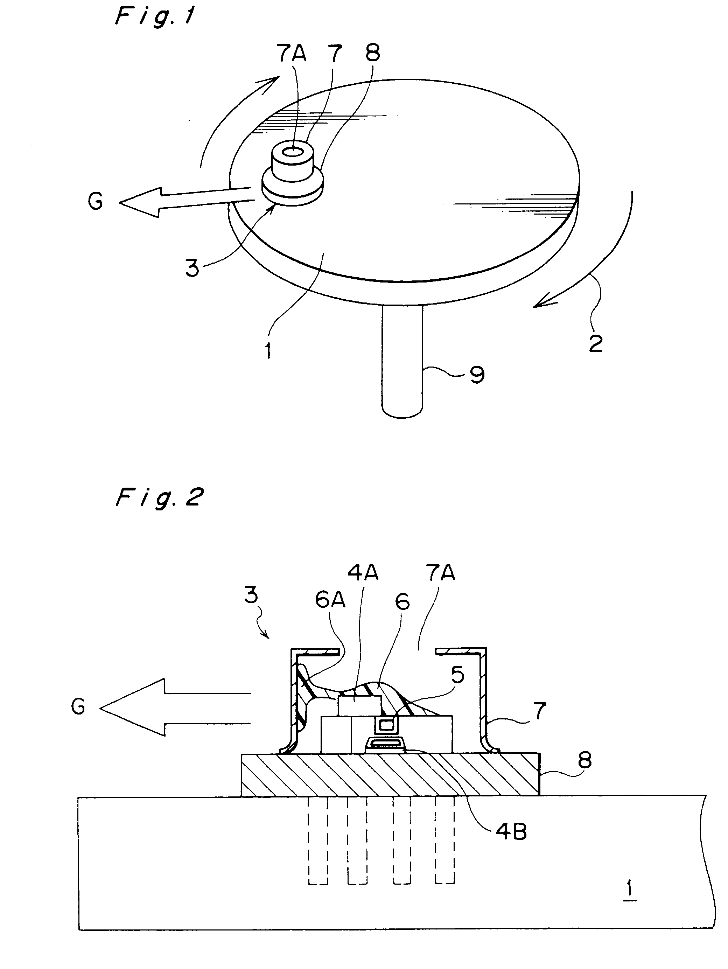

Reference is made to a resin coating method of the first embodiment.
(1) First, the semiconductor laser device 3 (stem 8) is mounted on a turntable 1 with the laser beam emission window 7A at the top of the cap 7 opened upward in a manner as shown in Figs. 1 and 2.
(2) Then, by means of an injector 18, a resin (fluorine based resin) 6 is potted on the semiconductor laser chip 5 and the photodiode chips 4A and 4B inside the cap 7 through the laser beam emission window 7A in a manner as shown in Fig. 5.
(3) Subsequently, as shown in Fig. 1, the turntable 1 is made to spin (in the direction indicated by an arrow 2) around a vertical spindle 9 perpendicular to the turntable 1. Consequently, the semiconductor laser device 3 receives a centrifugal force G. By an effect of the centrifugal force G, a superfluous portion 6A of the potted resin 6 flows toward the internal wall of the cap 7, as shown in Fig. 2. As a result, the resin 6 remains thinly (thickness: not greater than 500 µm) and uniformly on the surfaces of the semiconductor laser chip 5 and the photodiode chips 4A and 4B. Therefore, the surfaces of the semiconductor laser chip 5 and the photodiode chips 4A and 4B can be coated thinly and uniformly with the resin 6.

### (Second Embodiment)

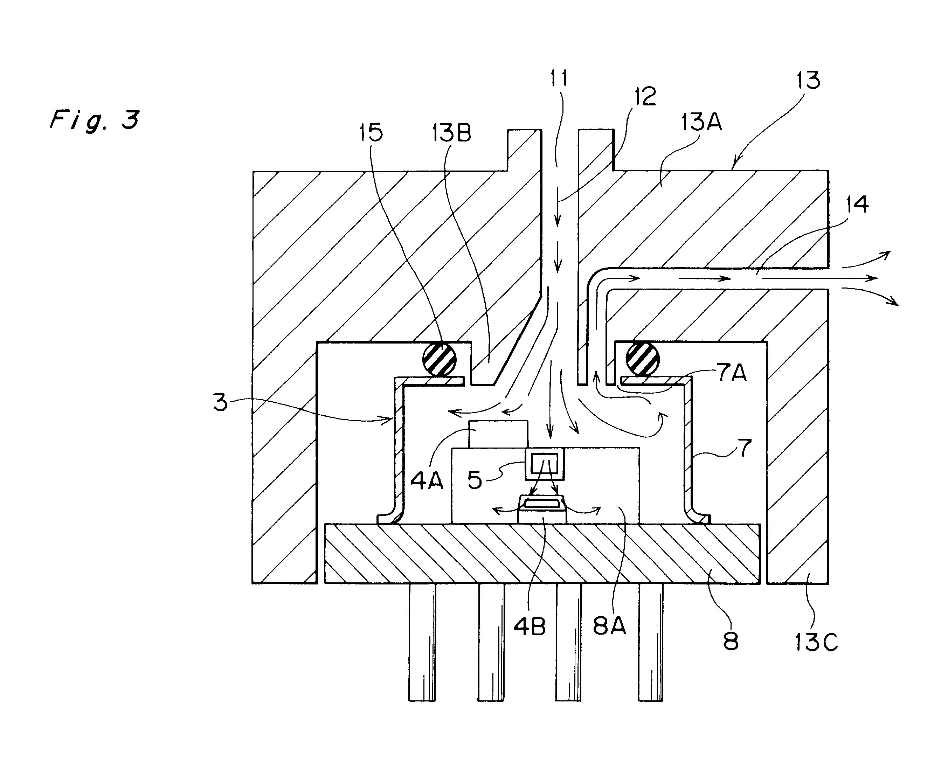

Reference is made to a coating method of the second embodiment.
(1) First, by means of an injector 18, a resin (fluorine based resin) 6 is potted on the semiconductor laser chip 5 and the photodiode chips 4A and 4B inside the cap 7 through the laser beam emission window 7A in a manner as shown in Fig. 5.
(2) Then an air blow device 13 is mounted around the laser beam emission window 7A of the cap 7 of the semiconductor laser device 3 in a manner as shown in Fig. 3.
   The air blow device 13 has a cylindrical portion 13C fitted around the stem 8 and a main portion 13A closing the upper end of the cylindrical portion 13C. In a middle portion of the main portion 13A, a projecting portion 13B which is fitted in the laser beam emission window 7A of the cap 7 is provided as projected downward. The air blow device 13 is provided with a gas supply path 11 penetrating in a vertical direction through the main portion 13A, and a gas discharge path 14 penetrating through the main portion 13A from the vertical direction to a radially outward direction (L-shaped). The gas supply path 11 and the gas discharge path 14 are forming respectively a gas inlet and a gas outlet in a lower surface of the projecting portion 13B. Around the projecting portion 13B is provided a shield ring 15 made of rubber to provide airtightness between the main portion 13A and the cap 7.
(3) Then nitrogen gas (or air) 12 having a relatively high pressure (200 to 300 kPa (2 to 3 kgf/cm²)) is made to flow into the cap 7 through the gas supply path 11, and the gas 12 is discharged to the outside of the cap 7 through the gas discharge path 14. With the above-mentioned arrangement, a superfluous portion of the potted resin is blown off to be discharged to the outside of the cap 7 together with the nitrogen gas 12. As a result, the resin 6 remains thinly and uniformly on the surfaces of the semiconductor laser chip 5 and the photodiode chips 4A and 4B. Therefore, the surfaces of the semiconductor laser chip 5 and the photodiode chips 4A and 4B can be coated thinly (thickness t: not greater than 500 µm) and uniformly with the resin 6.

### (Third Embodiment)

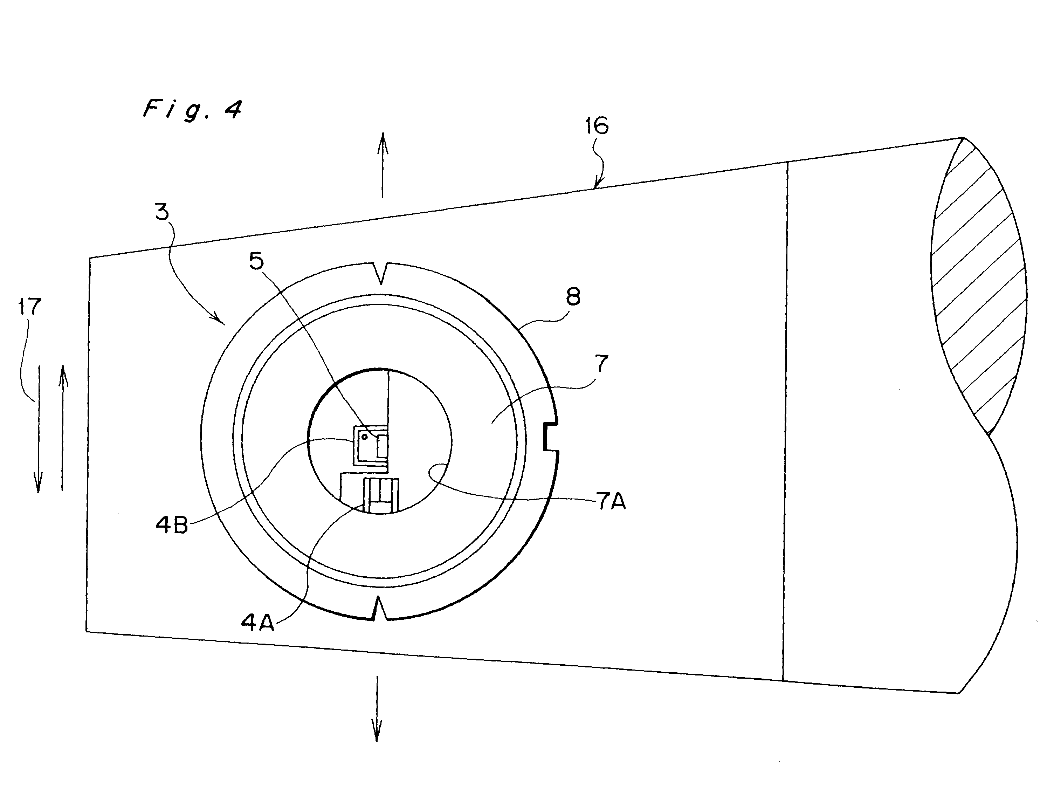

Reference is made to a coating method of the third embodiment.
(1) First, a semiconductor laser device 3 (stem 8) is mounted on a supersonic vibrator (supersonic horn) 16 with the laser beam emission window 7A of the cap 7 opened upward in a manner as shown in Fig. 4. Fig. 4 shows a top view of the semiconductor laser device 3 mounted to the supersonic vibrator 16.
(2) Then, by means of an injector 18, a resin (fluorine based resin) 6 is potted on the semiconductor laser chip 5, and the photodiode chips 4A and 4B inside the cap 7 through the laser beam emission window 7A in a manner as shown in Fig. 5.
(3) Subsequently, as shown in Fig. 4, the supersonic vibrator 16 is vibrated (power: 300 W) in an approximately horizontal direction indicated by an arrow 17 to scatter a superfluous portion of the potted resin 6 toward the internal wall of the cap 7. As a result, the resin 6 remains thinly and uniformly on the surfaces of the semiconductor laser chip 5 and the photodiode chips 4A and 4B. Therefore, the surfaces of the semiconductor laser chip 5 and the photodiode chips 4A and 4B can be coated thinly (thickness: not greater than 500 µm) and uniformly with the resin 6.

According to the coating method of the aforementioned first to third embodiments, the resin 6 is dropped on the semiconductor laser chip 5 and the photodiode chips 4A and 4B, and then an external force is applied to the dropped resin 6. Therefore, the superfluous portion of the resin 6 can be removed from the surfaces of the semiconductor laser chip 5 and the photodiode chips 4A and 4B. Therefore, the surfaces of the semiconductor laser chip 5 and the photodiode chips 4A and 4B can be coated thinly and uniformly with the resin 6.

Next, forward laser beam emission directions of a semiconductor laser chip 5 which is not coated with resin, a semiconductor laser chip 5 which is coated with a resin merely by the conventional potting technique, and a semiconductor laser chip 5 which is coated with a resin by the present invention are compared with each other in terms of a laser beam peak in a far-field pattern (FFP).

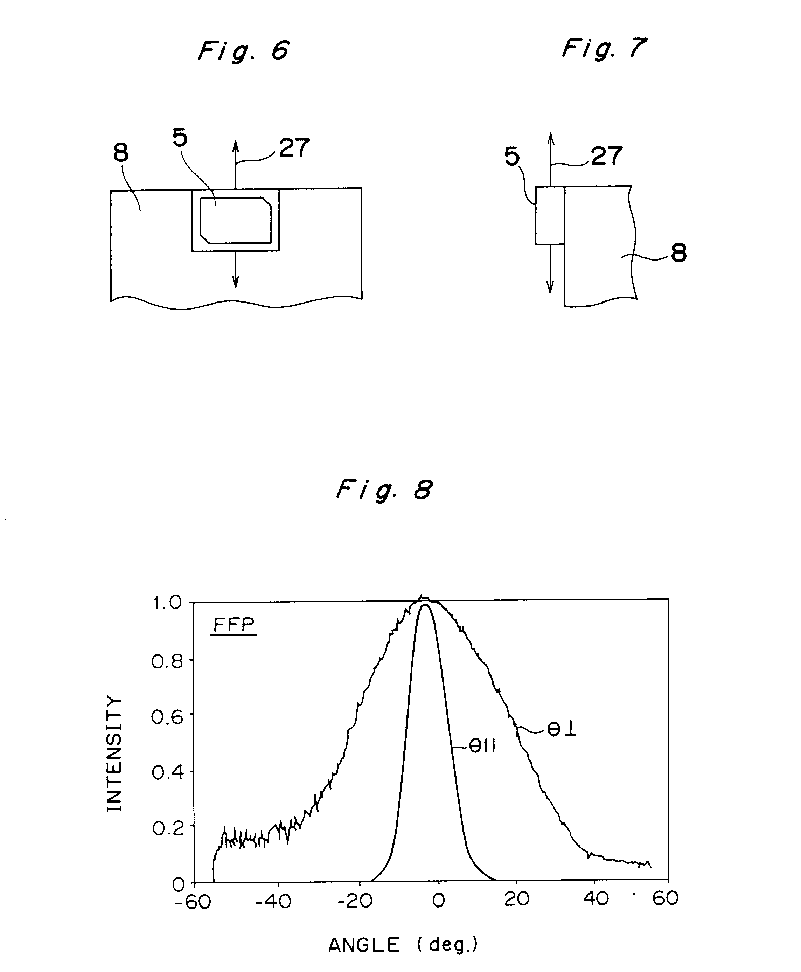

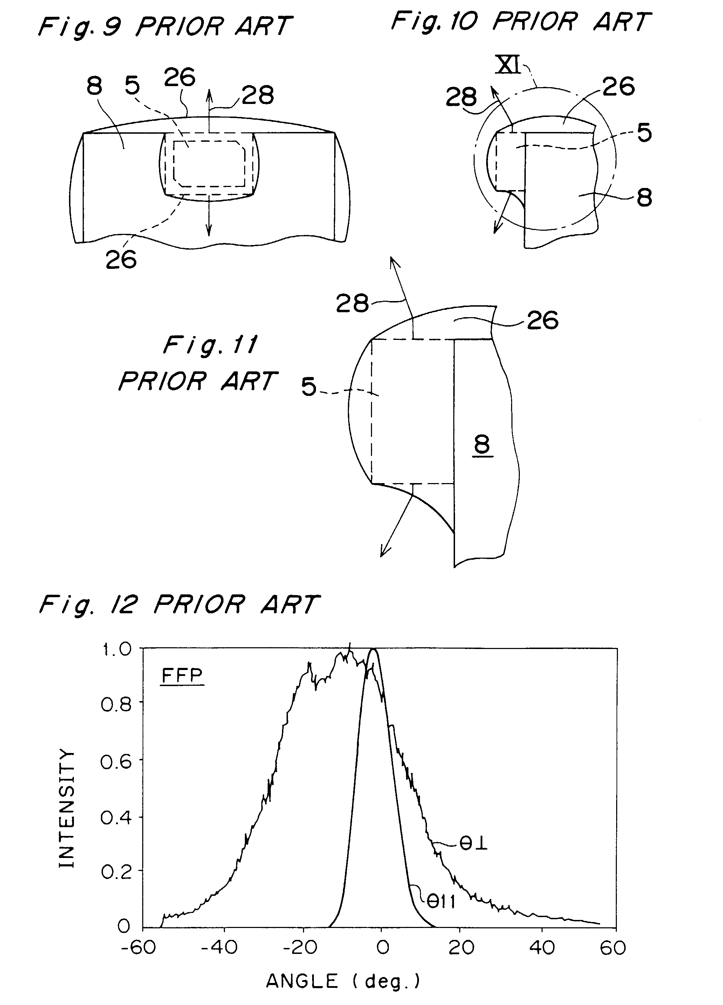

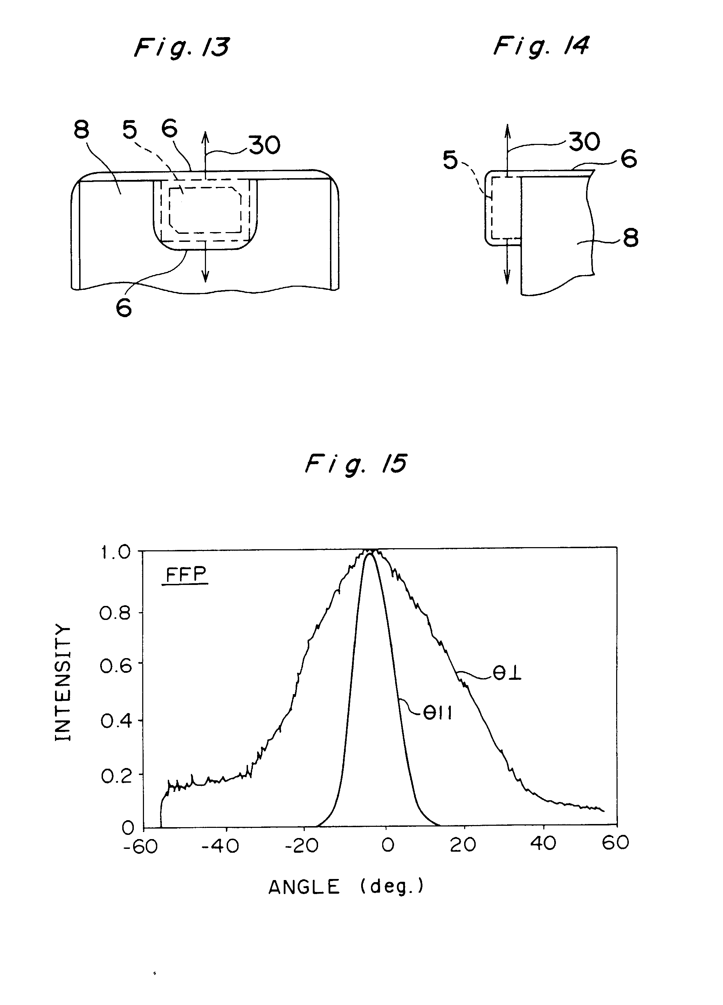

Fig. 6 is a front view of the semiconductor laser chip 5 which is not coated with resin, while Fig. 7 is a side view of the chip shown in Fig. 6. In regard to a laser beam emission direction 27, a front view angle θ∥ and a side view angle θ⊥ are each 0° (perpendicular to a plane in which the laser beam is emitted) as shown in Fig. 8. Fig. 9 is a front view of the semiconductor laser chip 5 which is coated with a resin merely by the conventional potting technique, while Fig. 10 is a side view of the chip shown in Fig. 9. In regard to a laser beam emission direction 28, although the front view angle θ∥ is 0°, the side view angle θ⊥ is -20° as shown in Fig. 12. The above is because the resin 26 having an ununiformed thickness operates as a lens in a manner as shown in Fig. 11. In other words, when the resin coating is achieved merely through potting, there is the drawback that the laser beam emission direction varies depending on a local nonuniformity of the resin. In contrast to the above, Fig. 13 shows a front view of the semiconductor laser chip 5 which is uniformly coated with resin by spin, air blow, or supersonic according to a method of the present invention. Fig. 14 shows a side view of the chip shown in Fig. 13. In regard to a laser beam emission direction 30, as shown in Fig. 15, the front view angle θ∥ and the side view angle θ⊥ are each improved to be 0°. The above is because the thickness of the resin coat is uniformalized and the resin 6 does not operate as a lens.

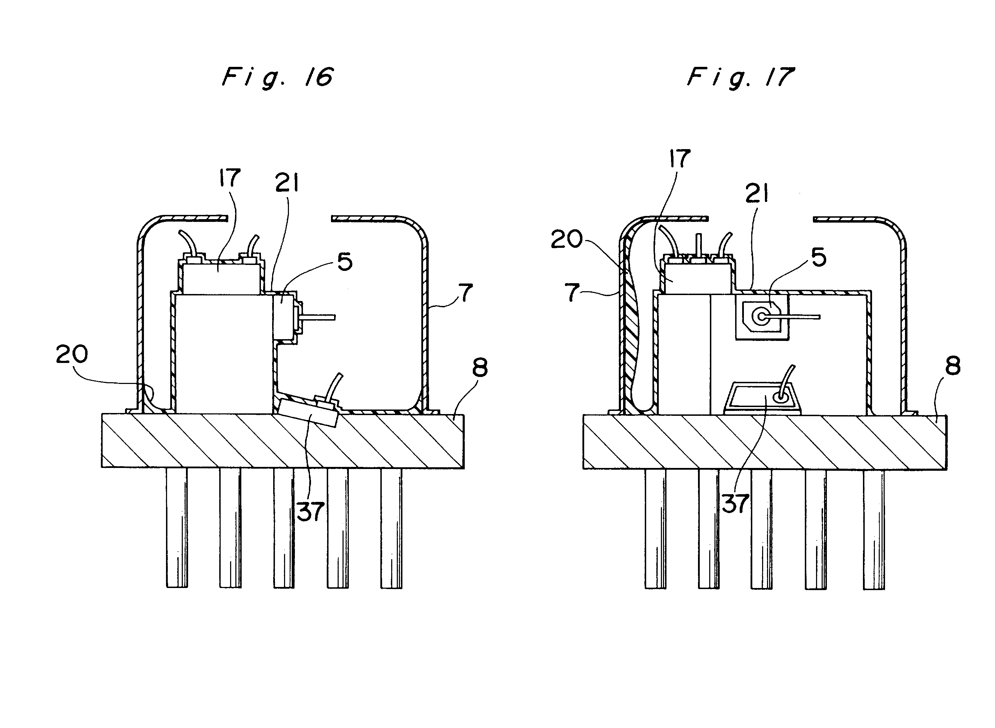

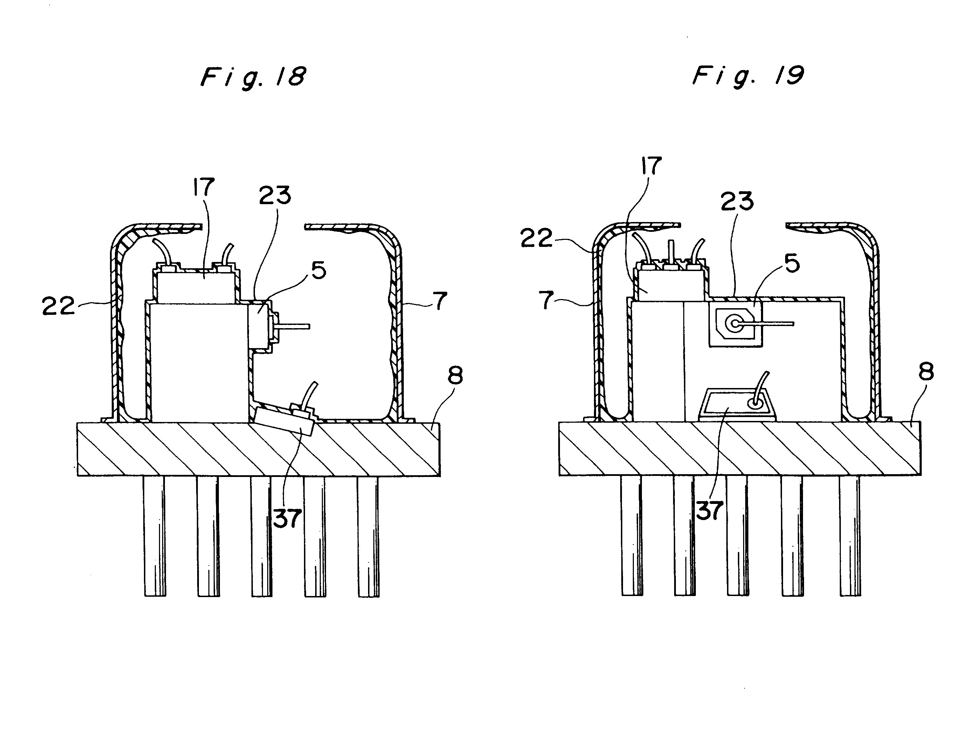

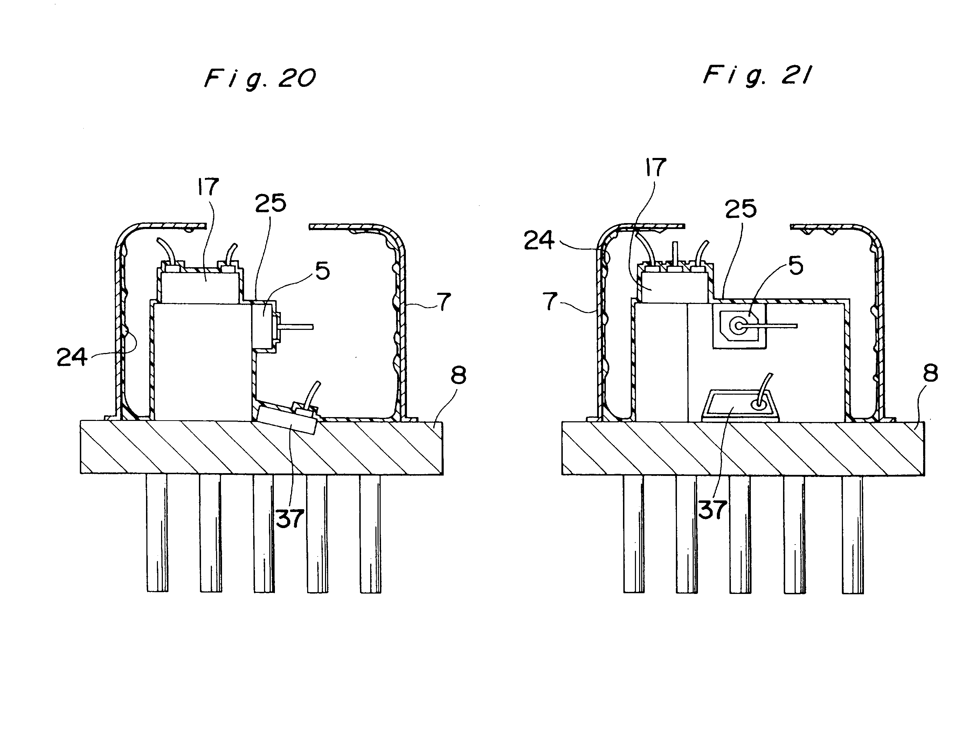

Fig. 16 shows the state of the resin coating inside the semiconductor laser device in a stage subsequent to the spin coating, while Fig. 17 shows a side view of the semiconductor laser device shown in Fig. 16. As is apparent from Figs. 16 and 17, the surfaces of the semiconductor laser chip 5 and photodiode chips 17 and 37 are uniformly coated with a resin 21, and a superfluous resin 20 is collected circumferentially in a certain position of the internal wall of the cap 7. Fig. 18 shows the state of the resin coating inside the semiconductor laser device in a stage subsequent to the air blow, while Fig. 19 shows a side view of the semiconductor laser device shown in Fig. 18. As is apparent from Figs. 18 and 19, the surfaces of the semiconductor laser chip 5 and photodiode chips 17 and 37 are uniformly coated with a resin 23, and a superfluous resin 22 is spread approximately uniformly to the internal wall of the cap 7. Fig. 20 shows the state of the resin coating inside the semiconductor laser device in a stage subsequent to the supersonic application, while Fig. 21 shows a side view of the semiconductor laser device shown in Fig. 20. As is apparent from Figs. 20 and 21, the surfaces of the semiconductor laser chip 5 and photodiode chips 17 and 37 are uniformly coated with a resin 25, and a superfluous resin 24 is scattered in spots on the internal wall of the cap 7.

According to the resin coating method for a semiconductor laser device of the first embodiment, the turntable mounted with the semiconductor laser device is made to spin around the vertical spindle approximately perpendicular to the turntable to flow the superfluous portion of the dropped resin toward the internal wall of the cap. The above-mentioned arrangement allows the surfaces of the semiconductor laser chip and the photodiode chip to be coated thinly and uniformly with the resin.

According to the resin coating method for a semiconductor laser device of the second embodiment, the gas is made to flow from the gas inlet of the air blow device into the cap, and then the gas is discharged from the gas outlet of the air blow device to discharge the superfluous portion of the dropped resin to the outside of the cap together with the gas. The above-mentioned arrangement allows the surfaces of the semiconductor laser chip and the photodiode chip to be coated thinly and uniformly with the resin.

According to the resin coating method for a semiconductor laser device of the third embodiment, the supersonic vibrator mounted with the semiconductor laser device (stem) is vibrated in the approximately horizontal direction to scatter the superfluous portion of the dropped resin toward the internal wall of the cap. The above-mentioned arrangement allows the surfaces of the semiconductor laser chip and the photodiode chip to be coated thinly and uniformly with the resin.

The invention being thus described, it will be obvious that the same may be varied in many ways. The scope of the invention is specified by the following claims.

## Claims

1. A method of resin coating a semiconductor laser device wherein a semiconductor laser chip (5) and a photodiode chip (4A, 4B) are mounted on a stem (8) and the chips are covered with a cap (7) which has a laser beam emission window at a top portion of the cap (7), the method comprising the step of:
dropping resin (6) on both the chips (5, 4A, 4B) inside the cap (7) through the laser beam emission window (7a);
wherein the method further comprises the steps of applying an external force on the dropped resin (6) to remove a superfluous portion (6A) of the dropped resin (6) from the surfaces of both the chips (5, 4A, 4B) whereby the thickness of the resin coating on both chips is reduced to less than 500µm.

2. A method of resin coating a semiconductor laser device as set forth in claim 1, and further comprising the step of fixing the stem (8) to a turntable (1) with the laser beam emission window (7A) opened upward; and wherein
the step of applying the external force on the dropped resin (6) comprises spinning the turntable (1) around a spindle (9) which extends in a direction approximately perpendicular to the turntable (1) to cause a superfluous portion (6A) of the dropped resin (6) to flow towards an internal wall of the cap (7).

3. A method of resin coating a semiconductor laser device as set forth in claim 1, and further comprising the step of mounting an air blow device (13) having a gas inlet (11) and a gas outlet (14) around the laser beam emission window (7A); and wherein
the step of applying the external force on the dropped resin comprises directing a gas (12) from the gas inlet (11) into the cap (7) and discharging the gas (12) from the gas outlet (14) to the outside of the cap (7) to discharge a superfluous portion of the dropped resin to the outside of the cap (7) with the gas (12).

4. A method of resin coating a semiconductor laser device as set forth in claim 1, and further comprising the step of fixing the stem (8) to a supersonic vibrator (16) with the laser beam emission window (7A) opened upward; and wherein
the step of applying the external force on the dropped resin comprises vibrating the supersonic vibrator (16) in an approximately horizontal direction to scatter a superfluous portion of the dropped resin toward an internal wall of the cap (7).

5. A method of resin coating a semiconductor laser device as set forth in claim 2, wherein the stem (8) is affixed to the turntable (1) at a position radially distant from the spindle (9).

## Patentansprüche

1. Harzbeschichtungsverfahren für ein Halbleiterlaser-Bauteil, bei dem ein Halbleiterlaserchip (5) und ein Photodiodenchip (4A, 4B) auf einem Unterbau (8) angebracht werden und die Chips mit einer Kappe (7) überdeckt werden, die in ihrem oberen Teil ein Laserstrahl-Emissionsfenster aufweist, mit den folgenden Schritten:
- Auftropfen von Harz (6) auf beide Chips (5, 4A, 4B) innerhalb der Kappe (7) durch das Laserstrahl-Emissionsfenster (7a) hindurch;
- wobei das Verfahren ferner die Schritte des Ausübens einer externen Kraft auf das aufgetropfte Harz (6) zum Entfernen eines überschüssigen Anteils (6A) des aufgetropften Harzes (6) von den Oberflächen beider Chips (5, 4A, 4B) umfasst, wodurch die Dicke der Harzbeschichtung auf beiden Chips auf weniger als 500 µm verringert wird.

2. Harzbeschichtungsverfahren für ein Halbleiterlaser-Bauteil nach Anspruch 1, ferner mit dem Schritt des Befestigens des Unterbaus (8) an einem Drehteller (1) in solcher Weise, dass das Laserstrahl-Emissionsfenster (7A) nach oben zeigt; und wobei
- der Schritt des Ausübens der externen Kraft auf das aufgetropfte Harz (6) das schnelle Drehen des Drehtellers (1) um eine Antriebsachse (9) umfasst, die sich in einer RIchtung ungefähr rechtwinklig zum Drehteller (1) erstreckt, um dafür zu sorgen, dass ein überschüssiger Anteil (6A) des aufgetropften Harzes (6) zur Innenwand der Kappe (7) fließt.

3. Harzbeschichtungsverfahren für ein Halbleiterlaser-Bauteil nach Anspruch 1, ferner mit dem Schritt des Anbringens einer Luftblasvorrichtung (13) mit einem Gaseinlass (11) und einem Gasauslass (14) um das Laserstrahl-Emissionsfenster (7A) herum; und wobei
- der Schritt des Ausübens der externen Kraft auf das aufgetropfte Harz das Einleiten von Gas (12) vom Gaseinlass (11) in die Kappe (7) und das Ausgeben des Gases (12) aus dem Gasauslass (14) zur Außenseite der Kappe (7) umfasst, um einen überschüssigen Anteil des aufgetropften Harzes zusammen mit dem Gas (12) zur Außenseite der Kappe (7) auszugeben.

4. Harzbeschichtungsverfahren für ein Halbleiterlaser-Bauteil nach Anspruch 1, ferner mit dem Schritt des Befestigens des Unterbaus (8) an einem Ultraschallschwinger (16) in solcher Weise, dass das Laserstrahl-Emissionsfenster (7A) nach oben geöffnet ist; und wobei
- der Schritt des Ausübens der externen Kraft auf das aufgetropfte Harz das In-Schwingung-Versetzen des Ultraschallschwingers (16) in ungefähr horizontaler Richtung umfasst, um einen überschüssigen Anteil des aufgetropften Harzes zur Innenwand der Kappe (7) zu verspritzen.

5. Harzbeschichtungsverfahren für ein Halbleiterlaser-Bauteil nach Anspruch 2, bei dem der Unterbau (8) an einer Position, die radial entfernt von der Antriebsachse (9) ist, am Drehteller (1) befestigt wird.

## Revendications

1. Procédé de revêtement par une résine d'un dispositif laser à semi-conducteur, dans lequel une puce laser à semi-conducteur (5) et une puce à photodiode (4A, 4B) sont montées sur une tige (8) et les puces sont recouvertes d 'une coiffe (7) qui présente une fenêtre d'émission du faisceau laser sur une partie supérieure de la coiffe (7) , le procédé comprenant les étapes consistant :
à verser la résine (6) sur les deux puces (5, AA, 4B) à l'intérieur de la coiffe (7) à travers la fenêtre (7a) d'émission du faisceau laser,
le procédé comprenant par ailleurs les étapes consistant à appliquer une force externe sur la résine versée (6) pour retirer une partie superflue (6A) de la résine versée (6) des surfaces des deux puces (5, 4A, 4B) de telle sorte que l'épaisseur de la résine recouvrant les deux puces soit réduite à moins de 500 µm.

2. Procédé de revêtement par une résine d'un dispositif laser à semi-conducteur selon la revendication 1 et comprenant par ailleurs l'étape consistant à fixer la tige (8) à un plateau tournant (1) de telle sorte que la fenêtre (7A) d'émission du faisceau laser soit ouverte vers le haut et dans lequel
l'étape d'application de la force externe sur la résine versée (6) comprend la mise en rotation du plateau tournant (1) autour d'une broche (9) qui s'étend dans une direction approximativement perpendiculaire au plateau tournant (1) de manière que la partie superflue (6A) de la résine versée (6) s'écoule vers une paroi interne de la coiffe (7).

3. Procédé d'application d'une résine sur un dispositif laser à semi-conducteur selon la revendication 1, et comprenant par ailleurs l'étape consistant à monter un dispositif de soufflage d'air (13) ayant une entrée de gaz (11) et une sortie de gaz (14) autour de la fenêtre (7A) d'émission du faisceau laser; et dans lequel
l'étape d'application de la force externe sur la résine versée consiste à diriger un gaz (12) de l'entrée de gaz dans la coiffe (7) et à décharger le gaz (12) par la sortie de gaz (14) vers l'extérieur de la coiffe (7) pour décharger une partie superflue de la résine versée vers l'extérieur de la coiffe (7) avec le gaz (12).

4. Procédé d'application d'une résine sur un dispositif laser à semi-conducteur selon la revendication 1, et comprenant par ailleurs, l'étape consistant à fixer la tige (8) à un vibrateur supersonique spécifié (16) de telle que la fenêtre (7A) d'émission du faisceau laser soit ouverte vers le haut; et dans lequel
l'étape d'application de la force externe sur la résine versée consiste à faire vibrer le vibrateur supersonique (16) dans une direction approximativement horizontale pour disperser une partie superflue de la résine versée vers une paroi interne de la coiffe (7).

5. Procédé d'application d'une résine sur un dispositif laser à semi-conducteur selon la revendication 2, dans lequel la tige (8) est fixée au plateau tournant (1) dans une position qui est distante de la broche (9) radialement.
